# EUROPEAN PATENT APPLICATION

(11) **EP 1 813 951 A1**
(43) Date of publication of application: **01.08.2007**
(21) Application number: 06250502.9
(22) Date of filing: 30.01.2006
(51) Int. Cl.: G01P 1/02, G01P 15/18

(54) **Inertial measurement unit and packages thereof**

(71) Applicant: Infineon Technologies SensoNor AS, 3192 Horten (NO)
(72) Inventor: Skog, Terje, 3180 Nykirke (NO); Kvisterøy, Terje, 3181 Horten (NO); Holm, Reidar, 3189 Horten (NO)
(74) Representative: Haley, Stephen

(57) **Abstract**

A package for at least one micromechanical sensor die having a sensing plane is provided. The package comprises a package body, internal electrical connectors arranged to internally electrically connect, in use, the package body with the at least one sensor die, and external electrical connectors arranged to externally electrically connect, in use, the package body with a printed circuit board (PCB). The external electrical connectors are arranged on the outside of at least two outer walls of the package body such that the package is connectable to the PCB in at least a first package orientation having a first sensing plane orientation relative to the plane of the PCB and a different second package orientation having a different second sensing plane orientation relative to the plane of the PCB.

An inertial measurement unit (IMU) is also provided.

## Description

The present invention relates to an inertial measurement unit, and packaging for such an inertial measurement unit, for a micromechanical system.

Assembly and packaging constitute a significant proportion of the manufacturing costs of micromechanical systems such as MEMS accelerometers and gyros. The assembly and packaging is also a major cause of reliability problems in such systems. Challenging diversified axis alignment is needed to measure inertial signals in such systems, and known systems employ complex sensing arrangements in order to achieve this. This is because inertial measurement units (IMUs) for use in inertial measurement systems are employed in a variety of applications, each of which requires a different set-up in relation to which axis or axes should be measured and the required combinations of angular (rotational) and linear (translational) measurement.

In known devices, packages are manufactured in which the inertial sensing chip of a package may need to have a different orientation to that of the plane of the printed circuit board (PCB) on which it is mounted. Considering a known cavity package, this needs to be mounted in the correct sensing plane of the PCB to allow for measurement in specific directions; for example, a cube structure may need to be built for mounting packaged sensors to allow for measurement in multiple specific directions, or each sensing element itself must to be designed for measuring in alternative sensing directions. Known IMUs provide for different axis combinations via complex 3D mechanical assemblies. The inflexibility of such a concept means that the user must often employ an IMU with more measurement capability than is required for the task in question. Such a lack of modularity means that unnecessarily costly and complex solutions are employed. Additionally, the complex mechanical and electrical assemblies used may also be prone to reliability problems, even where a simple inertial signal measurement is required.

The present invention seeks to solve or at least ameliorate the above problems by providing a package for at least one micromechanical sensor die having a sensing plane, the package comprising:
a package body;
internal electrical connectors arranged to internally electrically connect, in use, the package body with the at least one sensor die; and
external electrical connectors arranged to externally electrically connect, in use, the package body with a printed circuit board (PCB);
wherein the external electrical connectors are arranged on the outside of at least two outer walls of the package body such that the package is connectable to the PCB in at least a first package orientation having a first sensing plane orientation relative to the plane of the PCB and a different second package orientation having a different second sensing plane orientation relative to the plane of the PCB.

It is simple to arrange a package according to the present invention in alternative planes to the PCB if and when required. The package provides adjacent positioning of the sensing element and associated electronics, providing short wiring distances, and hence low parasitic losses and a compact package size.

The present invention further provides an inertial measurement unit (IMU) comprising one or more IMU modules, each module comprising:
one or more sensor dies, each sensor die positioned in substantially the same plane in use to define a sensor die plane;
each sensor die comprising one or more micromechanical sensing elements, each sensing element having a sensing axis the arrangement being such that there are at least two sensing elements within each IMU module;
a package for the one or more sensor dies, the package having a package body and internal electrical connectors arranged to internally electrically connect, in use, the package body with the one or more sensor dies;
wherein the orientation, in use, of the sensing axis of each sensing element relative to the sensor die plane is substantially identical.

Such a flexible, modular IMU is far cheaper to manufacture than comprehensive 3D IMUs, as the complexity of the unit can be suited to a diverse range of motion detection requirements depending on its intended use.

Examples of the present invention will now be described with reference to the accompanying drawings, in which:
Figures 1 a and 1b are a cross-sectional side view and a plane view, respectively, of a package according to the present invention;
Figure 2 shows the incorporation of one or two inertial sensing dies into the package;
Figures 3a to 3d show examples of inertial dies that can be arranged in identical packages;
Figures 4a to 4d show examples of a micromechanical sensing die and a semiconductor die arranged in a package; and
Figure 5 shows examples of arrangements of two IMUs oriented differently in order to provide a inertial measurement unit (IMU) system for sensing in a number of different directions.

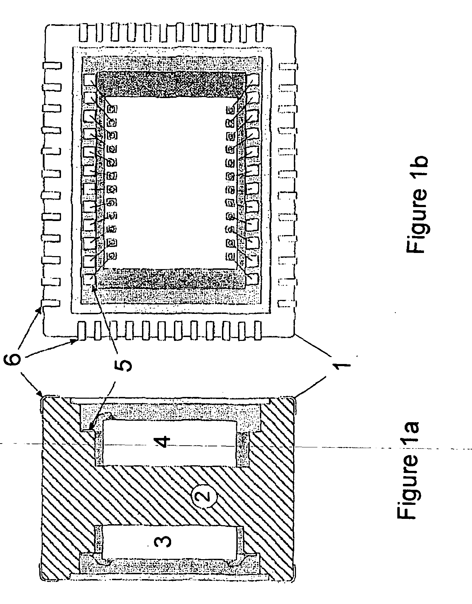

A cavity package 1 of figures 1a and 1b comprises a package body 2, which may be built from one or more of several standard packaging materials for semiconductors known in the art. The package body 2 is preferably built as a layered structure, the layers being parallel with internal chips 3 and 4 for easy connection and redistribution of signals. Chips 3 and 4 are typically inertial sensor dies, for use in devices such as MEMS accelerometers and gyros. The chips 3 and 4 are connected, using standard semiconductor methods such as wire-bonding, to internal pads 5. The cavity package 1 further comprises external electrical connections 6 which are attached via a standard connection principal such as solder bumps, surface connectors or pins along one or more side walls of the package 1. These external electrical connections 6 allow the cavity package 1 to be tilted on a printed circuit board (PCB). For example, several sides of the package 1 can be equipped with external connectors (each connector connected in parallel to the same internal pad) such that a single package can be mounted in a variety of different orientations, and such that a plurality of identical packages can be oriented differently to one another on the PCB, according to the required sensing direction(s) of a system.

A more complex example of such a cavity package according to the invention may have cavities on more than two sides thereof, in order to produce a device which is capable of sensing in several planes using the same sensing element.

A typical example of a more complex arrangement of the present invention is a double cavity ceramic package with an internal chip plane orientation situated at 90° to the PCB plane orientation.

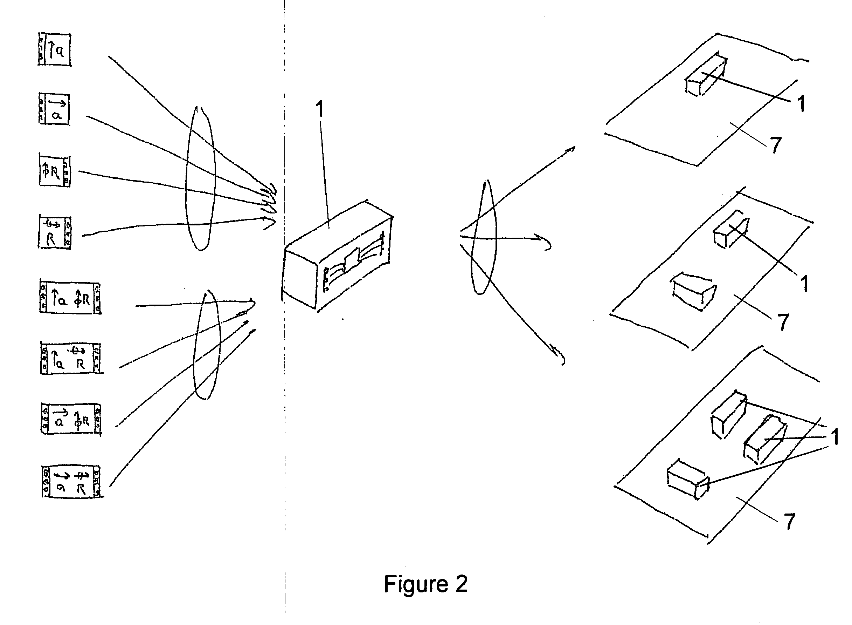

In figure 2, one or two sensing dies are combined in a single cavity package 1 to form an inertial measurement unit (IMU). The dies comprise only two basic sensing structures, one angular sensing structure "R" for measuring rotational movement (e.g. a gyro) and one linear sensing structure "a" for measuring translational movement (e.g. an accelerometer), such sensing structures being rotated with respect to the spatial coordinates determined by the orientation of the sensing axis with respect to the wire bonding pads. As figure 2 shows, one, two or three assembled packages 1 or IMUs are positioned on a PCB 7 to form a complete IMU system dependent on the requirements of the IMU application. Figure 2 further shows four sensing dies which combine the angular and linear sensors. Again, one, two or three assembled packages or IMUs 1 are used to form a complete IMU system dependent on the requirements of the IMU application.

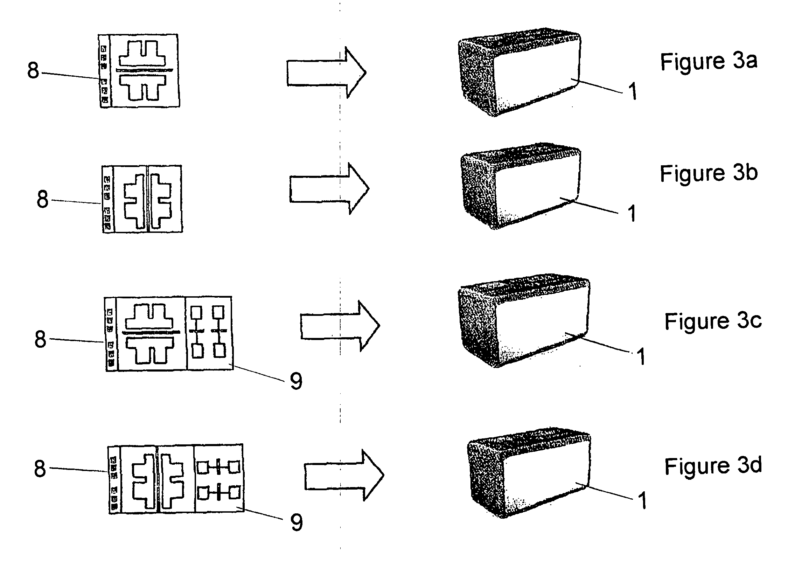

Figure 3a shows a gyro sensing die 8 which can be incorporated in a package 1 according to the present invention, while figure 3b shows a similar gyro die 8 arranged in a different orientation to that of figure 3a. The gyro die 8 can be arranged together with an accelerometer 9 within the package 1 (figure 3c), and can be arranged in alternative orientations, as shown by the of figure 3d where the orientation of gyro die 8 and accelerometer 9 are rotated with respect to those of figure 3c.

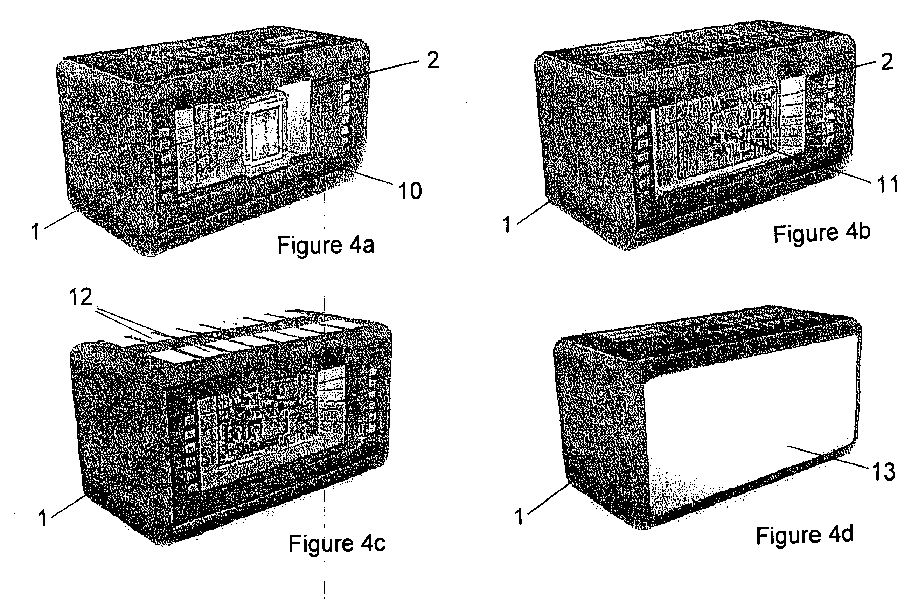

Figures 4a to 4d show multilayer packaging arrangements employing a standard version of the package 1 of the present invention. In this example the external electrical connections 6 are only present on one side of the package. Figure 4a illustrates a sensor die 10 mounted on a first side of a layer of the package body 2, while figure 4b illustrates, for example, an ASIC die 11 mounted to a second side of the package body 2. One side of the package is provided with attachment means 12 such as soldering pads suitable for attaching the package to the PCB. The cavity package can optionally be covered with lids and/or filled with cover-material 13 such as soft gels, etc, as shown in figure 4d.

The modular structure of the IMUs of the present invention mean that a set of two basic sensing structures, a single-axis angular sensor and a single-axis linear sensor (for example a gyro and accelerometer, respectively) can be realised as a set of four sensing dies, two optional orthogonal in plane sensing directions for each type in a single package, in order to allow for 63 basic realisations of IMU systems covering known 3D spatial measurement of one to six degrees of freedom, through the use of one, two or three assembled packages of the type shown in figure 4 (i.e. 17 realisations with one IMU, 31 realisations with two IMUs and 15 realisations with three IMUs) on a PCB. The packages used are simple, lacking the complexity of known devices, and have the obvious advantages of simple standard assembly and test processes.

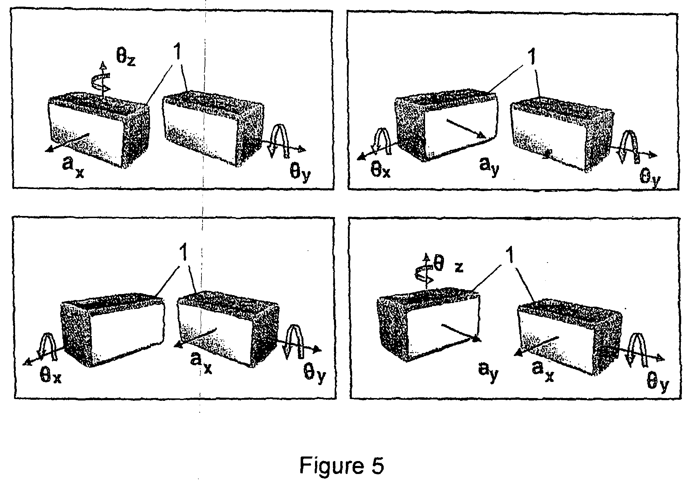

Figure 5 shows examples of how parameters can be sensed in different directions in accordance with the standard package and IMU. Typically in such devices, the sensing axis is in the plane of the sensing die, the sensing die is arranged "vertically" in the package 1 and the package 1 is mounted "horizontally" on the PCB 7. Alternatively, one or both of the sensing structures has a sensing direction which is normal to the die plane.

The present invention therefore provides a standard package and IMU that can be used to provide a flexible, modular IMU system. The arrangement of the package/IMU(s) of the IMU system allows for the diverse needs of fields such as motion detection, in contrast to a complex, high cost, comprehensive 3D IMU.

## Claims

1. A package for at least one micromechanical sensor die having a sensing plane, the package comprising:
a package body;
internal electrical connectors arranged to internally electrically connect, in use, the package body with the at least one sensor die; and
external electrical connectors arranged to externally electrically connect, in use, the package body with a printed circuit board (PCB);
wherein the external electrical connectors are arranged on the outside of at least two outer walls of the package body such that the package is connectable to the PCB in at least a first package orientation having a first sensing plane orientation relative to the plane of the PCB and a different second package orientation having a different second sensing plane orientation relative to the plane of the PCB.

2. A package according to claim 1, wherein the package body is formed of a ceramic material.

3. A package according to claim 1 or 2, wherein the at least one sensor is an inertial sensor chip.

4. A package according to claim 3, wherein the package body is structured in layers, the layers being arranged to be parallel to a plane of each inertial sensor chip.

5. An inertial measurement unit (IMU) comprising one or more IMU modules, each module comprising:
one or more sensor dies, each sensor die positioned in substantially the same plane in use to define a sensor die plane;
each sensor die comprising one or more micromechanical sensing elements, each sensing element having a sensing axis the arrangement being such that there are at least two sensing elements within each IMU module;
a package for the one or more sensor dies, the package having a package body and internal electrical connectors arranged to internally electrically connect, in use, the package body with the one or more sensor dies;
wherein the orientation, in use, of the sensing axis of each sensing element relative to the sensor die plane is substantially identical.

6. An IMU system comprising a plurality of IMUs according to claim 5; and
external electrical connectors arranged to externally electrically connect, in use, a package body of the package of each IMU with a printed circuit board (PCB),
wherein the packages of the IMUs are substantially identical.
